# EUROPÄISCHE PATENTANMELDUNG

(11) **EP 1 313 221 A1**
(43) Veröffentlichungstag der Anmeldung: **21.05.2003**
(21) Anmeldenummer: 02025439.7
(22) Anmeldetag: 15.11.2002
(51) Int. Cl.: H03K 17/16

(54) **Verfahren zur Ansteuerung von Leistungshalbleitermodulen**

(30) Priorität: 17.11.2001 DE 10156618
(71) Anmelder: Semikron Elektronik GmbH Patentabteilung, 90253 Nürnberg (DE)
(72) Erfinder: Mourick, Paul, Dr., 90766 Fürth (DE)

(57) **Zusammenfassung**

Verfahren zur Ansteuerung von Leistungshalbleitermodulen bestehend aus mindestens zwei parallel und / oder antiparallel geschalteten Leistungshalbleiterbauelementen, wovon mindestens ein Element ein Leistungstransistor ist, wobei PETT-Schwingungen (PETT = plasma extraction transit time), hervorgerufen durch die Parallel- bzw. Antiparallelschaltung der Leistungshalbleiterbauelemente, unterdrückt werden, indem mindestens ein Leistungstransistor mittels eines weiteren Ansteuerimpulses nach der Abschaltung erneut angesteuert wird.

## Beschreibung

Die Erfindung beschreibt ein Verfahren zur Ansteuerung von hinlänglich bekannten Leistungshalbleitermodulen. Derartige Leistungshalbleitermodule bestehen aus mindestens einem Leistungsschalter, einem isolierenden Substrat und einem Gehäuse, wobei ein Leistungsschalter bei den meisten Leistungshalbleitermodulen nach dem Stand der Technik aus mehreren Leistungstransistoren besteht. Diese Leistungsschalter bestehen beispielsweise aus einer Parallelschaltung mehrerer MOS-FETs oder aus einer Parallelschaltung von mehreren IGBTs mit einer oder mehreren antiparallel dazu geschalteten Leistungsdioden (Freilaufdioden).

Bereits zwei parallel geschaltete IGBTs oder auch ein IGBT und eine antiparallel geschaltete Freilaufdiode können eine Abschaltschwingung, eine sog. PETT- Schwingung (PETT = plasma extraction transit time) [Proceedings of the 31^{th} European Solid-State Device Research Conference 2001, Seite 255-258], erzeugen. Nach dem Abschalten eines aus mindestens zwei Halbleiterbauelementen gebildeten Leistungsschalters treten dann im Emitter- Kollektorkreis hochfrequente Schwingungen mit einer Frequenz von einigen Hundert Megahertz auf. Diese PETT- Schwingungen führen zu einem abgestrahlten elekromagnetischen Feld, das als Störsignal z.B. in EMV- Messungen detektiert werden kann.

Bisher sind zwei Lösungsansätze zur Vermeidung von PETT- Schwingungen bekannt.

Aus der DE 195 49 011 ist mindestens eine zusätzliche Verbindungsleitung bekannt, die die Emitterkontakte zweier direkt benachbarter IGBT- Bauelemente elektrisch miteinander verbindet. Auf diese Weise ändert sich die Induktivität der Verbindung der beiden IGBT-Bauelemente. Die Änderung der Induktivität zieht eine Änderung der Resonanzfrequenz des aus der Kapazität der Bauelemente bzw. des Substrates und der Induktivität der Verbindungen gebildeten Schwingkreises nach sich. Durch diese Änderung fällt diese Resonanzfrequenz nicht mehr mit der Frequenz der laufzeitbedingten Ausräumvorgänge des p-n Übergangs zusammen und es entsteht keine PETT- Schwingung.

Allerdings löst diese rein mechanisch erfolgte Unterdrückung der PETT-Schwingungen nicht in allen Fällen die gestellte Aufgabe. In bestimmten durch ihre geometrischen Abmessungen bevorzugten Schaltungsanordnungen führt dies zu einer zufriedenstellenden Unterdrückung der PETT-Schwingung, bei anderen Geometrien von Schaltungsanordnungen ist dies allerdings nicht erfolgreich, die PETT-Schwingungen werden hier nicht oder nur unvollständig unterdrückt.

Ebenso kann eine geänderte Bestückung des Leistungshalbleitermoduls mit anderen Leistungsschaltern die Qualität oder Wirkung der Unterdrückung beeinflussen. Weiterhin ist diese Lösung auf Leistungstransistoren beschränkt, antiparallel geschaltete Freilaufdioden können nicht in der Unterdrückung berücksichtigt werden.

Die DE 199 38 302 stellt eine Schaltungsanordnung für Leistungshalbleitermodule vor, bei der die Kupferkaschierung des Substrates im Bereich der Emitter und / oder im Bereich des Kollektors eines IGBT- Bauelements mindestens eine unkaschierte Stelle aufweist und die IGBT- Bauelemente eng benachbart angeordnet sind. Die unkaschierten Stellen führen zu einer Veränderung des Ohmschen Widerstandes und induzieren auf der Rückseite des Substrates Wirbelströme, die dem ursprünglichen Magnetfeld der parasitären Induktivität entgegengerichtet sind.

Nachteilig an dieser Lösung ist, dass für jede geometrische Anordnung der Bauelemente auf dem Substrat die Lage der unkaschierten Stellen neu bestimmt werden muss. Hier erweisen sich verschieden Änderungen sowohl geometrischer Art als auch in der Bestückung mit Bauelementen als Bedingung für eine neue Bestimmung der Anzahl, Lage, Größe und Form der unkaschierten Stellen.

Die vorliegende Erfindung hat die Aufgabe, ein Verfahren zur Ansteuerung von Leistungshalbleitermodulen, bestehend aus einer oder mehreren funktionalen Gruppen von mindestens zwei parallel und / oder antiparallel geschalteten Leistungshalbleiterbauelementen, wovon mindestens ein Element mindestens einer Gruppe ein Leistungstransistor ist, vorzustellen, bei dem PETT-Schwingungen wirksam und unabhängig von der geometrischen Anordnung auf dem Substrat unterdrückt werden.

Die Aufgabe wird gelöst durch die Maßnahmen des Anspruchs 1. Weitere vorteilhafte Ausgestaltungen sind in den Unteransprüchen genannt.

Der Grundgedanke der Erfindung ist eine aktive Beeinflussung der Mechanismen, die zur Erzeugung von PETT-Schwingungen führen. Dies kann somit keine mechanische oder geometrische Änderung des Leistungshalbleitermoduls selbst bedeuten. Die Entstehung der PETT-Schwingungen hängt von der Dicke der Raumladungszone und vom Injektionswirkungsgrad der Löcher aus der Plasmazone in die Raumladungszone ab. In die Raumladungszone fließt in dem "Tailphase" genannten Zeitraum nach der Abschaltung des Leistungstransistors ein reiner Löcherstrom, wenn Stoßionisation vernachlässigt werden kann. Die für die Erzeugung der PETT-Schwingung erforderliche Schwingungsbedingung ist ein durch die Laufzeit der Löcher durch die Raumladungszone bedingter negativer Widerstand und daraus folgend eine Phasenverschiebung zwischen dem Strom und der Spannung von mehr als 90°. Erfindungsgemäß wird diese Bedingung gestört und damit das Auftreten von PETT-Schwingungen wirksam verhindert durch die Injektion von Elektronen in die Raumladungszone. Diese Injektion von Elektronen wird durch ein zeitlich begrenztes Wiedereinschalten der Ansteuerung des Leistungstransistors erreicht.

Dieses Wiedereinschalten durch die Ansteuerschaltung kann im einfachsten Fall erfolgen, indem innerhalb der Ansteuerschaltung vorgegebene Werte der Dauer sowie der Länge der Einschaltzeit des weiteren Ansteuerimpulses verwendet werden. Dies hat den Vorteil, keinerlei konstruktive Veränderungen an dem Leistungshalbleitermodul selbst vornehmen zu müssen und ist somit auch für existierende Module anwendbar.

Eine weitere Möglichkeit, das Wiedereinschalten durch die Ansteuerschaltung zu bestimmen, geschieht durch Messung der abgestrahlten Leistung und / oder Frequenz der PETT-Schwingung. Somit lässt sich die korrekte, für die jeweilige Schwingungscharakteristik ideale Dauer und Länge der Einschaltzeit bestimmen und daraus die entsprechenden Ansteuerimpulse erzeugen. Dies ist die flexibelste, aber auch aufwendigste Möglichkeit zur erfinderischen Unterdrückung von PETT-Schwingungen.

In einem Verfahren, das aus einer Mischung beider oben genannter Verfahren besteht, werden die Dauer und Länge der Einschaltzeit bestimmt aus einer hinterlegten Tabelle und unter Einbeziehung mindestens einer leicht zugänglichen Messgröße, wie z.B. der Feldstärke der abgestrahlten Leistung. Hieraus erzeugt die Ansteuerung die entsprechenden Ansteuerimpulse.

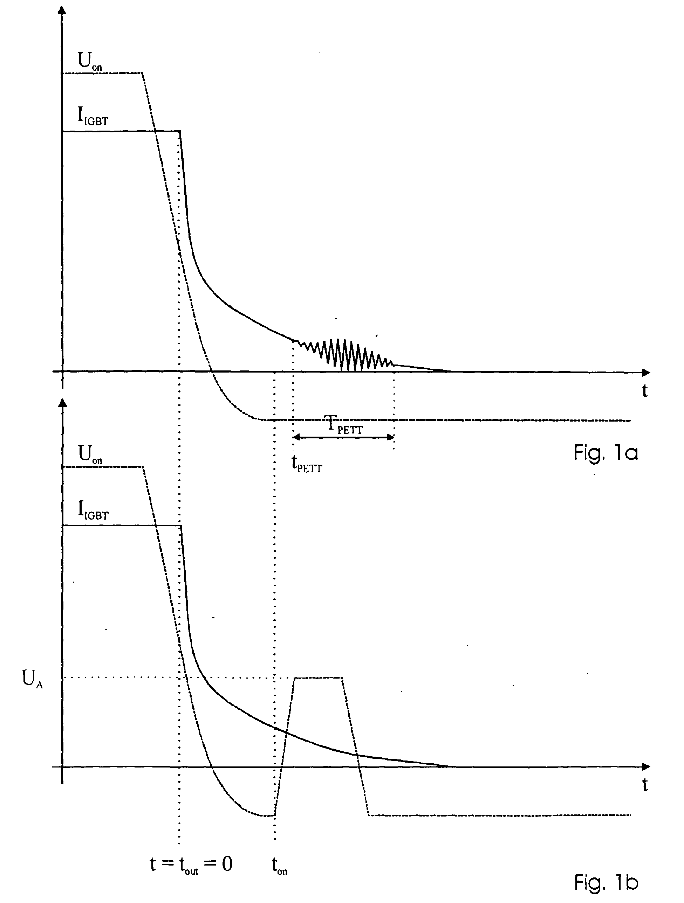

Die erfinderische Lösung wird an Hand der Fig. 1 weiter erläutert.

Fig. 1a zeigt in einer Simulation das Auftreten einer PETT-Schwingung in einer Parallelschaltung von 2 IGBTs ohne die erfinderische Unterdrückung dieser Schwingung. Nach dem Abschalten t = tₒᵤₜ = 0 des IGBTs sinkt der Wert des durch den IGBT fließenden Stromes (I_{IGBT}) stetig bis zum Zeitpunkt t = t_{PETT} ≈ 2µs die PETT-Schwingung mit einer Frequenz von ca. 800MHz (hier nur schematisch dargestellt) beginnt. Die Schwingungsdauer (T_{PETT}) beträgt hier ca. 1,5µs. Weiterhin dargestellt ist der Verlauf der durch die Ansteuerung erzeugten Ansteuerspannung (Uₒₙ) für den IGBT. Durch Wiedereinschalten dieser Steuerspannung (Fig. 1b) zum Zeitpunkt t = tₒₙ = 1,8µs < t_{PETT}, der vor dem Beginn der PETT-Schwingung liegt, wird diese unterdrückt. Hierbei muss die Spannung (U_{A}) mindestens 0,5V höher sein als die Gate- Schwellenspannung (Uₜₕ) des IGBTs. Sie sollte allerdings diese Spannung um nicht mehr als 3V übersteigen. Die Länge dieses Wiedereinschaltimpulses Tₒₙ = 1µs ≈ T_{PETT} muss dabei ungefähr gleich der Länge der ansonsten entstehenden PETT-Schwingung sein. Höhere Spannungen oder eine längere Einschaltdauer würden die Ausschaltverluste im IGBT erheblich erhöhen und damit die Funktionsfähigkeit des gesamten Leistungshalbleitermoduls beieinträchtigen.

In der folgenden Tabelle sind die wichtigsten Kenngrößen der Erfindung und deren Zusammenhänge zusammengefasst:

| ***Kenngröße*** | | ***Wertbereich*** |
|---|---|---|
| Beginn der PETT-Schwingung (nach dem Abschaltzeitpunkt tₒᵤₜ des Leistungstransistors) | t_{PETT} | 0,5µs ... 3µs |
| Wiedereinschaltzeitpunkt der Ansteuerung | tₒₙ (< t_{PETT}) | 0,3µs ... 2,8µs |
| Dauer der PETT-Schwingung | T_{PETT} | 0,5µs ... 1,5µs |
| Länge dieses Wiedereinschaltimpulses | Tₒₙ (≈ T_{PETT}) | 0,5µs ... 1,5µs |
| Spannung des Wiedereinschaltimpulses | Vₒₙ | Vₜₕ + (0,5V ... 3V) |

## Patentansprüche

1. Verfahren zur Ansteuerung von Leistungshalbleitermodulen bestehend aus einer oder mehreren funktionalen Gruppen von mindestens zwei parallel und / oder antiparallel geschalteten Leistungshalbleiterbauelementen, wovon mindestens ein Element mindestens einer Gruppe ein Leistungstransistor ist und zum Zweck der Stromleitung für eine bestimmte Leitungszeitspanne durch eine Ansteuerschaltung angeschaltet ist, wobei PETT-Schwingungen, hervorgerufen durch die Parallel- bzw. Antiparallelschaltung der Leistungshalbleiterbauelemente, unterdrückt werden, indem mindestens ein Leistungstransistor derart durch die Ansteuerschaltung angesteuert wird, dass im Zeitraum von 0,5µs bis 3µs nach dem Ende der Leitungszeitspanne mindestens ein weiterer Ansteuerimpuls von 0,5µs bis 2µs Länge mit einer Ansteuerspannnung, die 0,5V bis 3V größer als die Gate- Schwellenspannung des Leistungstransistors ist, folgt.

2. Verfahren nach Anspruch 1 **dadurch gekennzeichnet, dass**
die Ansteuerschaltung konstruktiv fest vorgegebene Werte des Einschaltzeitpunktes und der Länge des weiteren Ansteuerimpulses verwendet.

3. Verfahren nach Anspruch 1 **dadurch gekennzeichnet, dass**
die Ansteuerschaltung durch Messung der abgestrahlten Leistung und / oder Frequenz der PETT-Schwingung den korrekten Einschaltzeitpunkt und die Länge des weiteren Ansteuerimpulses errechnet.

4. Verfahren nach Anspruch 1 **dadurch gekennzeichnet, dass**
die Ansteuerschaltung durch eine hinterlegte Tabelle und unter Einbeziehung weiterer Messgrößen den korrekten Einschaltzeitpunkt und die korrekte Länge des weiteren Ansteuerimpulses ermittelt.
